# EUROPÄISCHE PATENTSCHRIFT

(11) **EP 2 936 944 B1**
(45) Veröffentlichungstag und Bekanntmachung des Hinweises auf die Patenterteilung: **24.07.2019**
(21) Anmeldenummer: 13803026.7
(22) Anmeldetag: 12.12.2013
(51) Int. Cl.: H05K 1/02, H05K 1/03, H01L 33/64, H05K 3/00

(54) **BAUELEMENTTRÄGER UND BAUELEMENTTRÄGERANORDNUNG**
COMPONENT CARRIER AND COMPONENT CARRIER ARRANGEMENT
SUPPORT DE COMPOSANT ET DISPOSITIF SUPPORT DE COMPOSANT

(30) Priorität: 21.12.2012 DE 102012113014
(43) Veröffentlichungstag der Anmeldung: 28.10.2015
(73) Patentinhaber: TDK Electronics AG, 81671 München (DE)
(72) Erfinder: FEICHTINGER, Thomas, A-8010 Graz (AT); PECINA, Axel, A-8543 St. Martin (AT)
(74) Vertreter: Epping - Hermann - Fischer
(86) Internationale Anmeldenummer: PCT/EP2013/076426
(87) Internationale Veröffentlichungsnummer: WO 2014/095587

(56) Entgegenhaltungen:
- EP-A1- 2 330 639
- EP-A1- 2 437 581
- EP-A2- 0 926 729
- DE-A1-102009 010 179
- US-A- 5 731 067
- US-A1- 2008 043 444
- US-A1- 2010 181 105

## Beschreibung

Die Erfindung betrifft einen Bauelementträger mit einem Mehrschichtträgerkörper, der ein Substrat aufweist, eine Bauelementträgeranordnung und ein Verfahren zur Herstellung eines solchen Mehrschichtträgerkörpers.

Beim Design von Trägern für Hochleistungschips, so genannte High-Power-Chipträger, wie sie beispielsweise für Leuchtdiodensysteme mit hoher Helligkeit, so genannte High-Brightness-LED-Systeme oder HB-LED-Systeme, verwendet werden, spielen thermisches Management, Lichtausbeute und Lebensdauer eine immer wichtigere Rolle. Durch effizientes Wärmemanagement können die Leistungsreserven der Leuchtdioden, kurz LEDs, genutzt werden. Dabei spielt die thermische Performance des LED-Trägers eine entscheidende Rolle im Gesamtsystem. Hohe thermische Leitfähigkeiten des Trägermaterials, die größer als 100 W/mK sind, werden in HB-LED-Anwendungen gewünscht. Weitere Bauelemente zum Schutz der Schaltungsanordnung können ebenfalls auf dem Träger vorgesehen sein.

Eine wichtige Anforderung an den Träger ist außerdem, dass das als Wärmequelle wirkende Bauelement möglichst nahe am Wärmesenkenelement an der Trägerunterseite positioniert ist, was eine dünne Ausführung des Trägers von üblicherweise weniger als 500 µm erfordert. Außerdem wird zwischen der Wärmequelle und dem Wärmesenkenelement eine elektrische Isolation gewünscht, die üblicherweise eine Spannungsfestigkeit von 3000 V erfüllen soll.

Üblicherweise ist die Wärmequelle beziehungsweise das als Wärmequelle wirkende Bauelement an der Oberseite des Trägers positioniert und das Wärmesenkenelement ist an der Unterseite des Trägerkörpers angeordnet, wobei eine gute Wärmeableitung von der Wärmequelle zum Wärmesenkenelement gewünscht ist.

Bisher wurden die LEDs und Schutzbauelemente, beispielsweise ein TVS-Element (Transient-Voltage-Suppressor-Element oder Suppressordiode) auf einem Keramikträger, der beispielsweise Materialien aus der Gruppe AlOx, A1N umfasst, oder einem Siliziumträger aufgebaut, wobei die LED auf die ebene Trägerfläche aufgesetzt wird. Dies ist ein so genanntes Level-1-System mit LED und einem Träger sowie einem Schutzbauelement. Wird dieses Level-1-System auf einen weiteren Träger montiert, spricht man von einem Level-2-System.

Die US 5,731,067 A zeigt einen Mehrschichtträgerkörper mit einem metallenen Bereichs im Substrat. Die US 2008/043444 A1 zeigt einen Träger mit einer Wärmesenke im Substrat.

Die EP 2330639 A1 zeigt ein LED-Modul mit einer Wärmesenke, die sich in das Substrat erstreckt, und einer wärmeableitenden Platte.

Die EP 0926729 A2 zeigt ein Halbleiter-Plastik-Package. Die US 2010/181105 A1 zeigt einen Mehrschichtträgerkörper. Die DE 102009010179 A1 zeigt Mehrschichtträgerkörper mit schräg hineinragender Reflektorwand. Die EP 2437581 A1 zeigt einen Mehrschichtträgerkörper.

Es ist die Aufgabe der Erfindung, einen Bauelementträger und eine Bauelementträgeranordnung bereitzustellen, die eine gute Wärmeableitung ermöglichen.

Die Aufgabe wird gelöst durch einen Bauelementträger und eine Bauelementträgeranordnung mit den Merkmalen der nebengeordneten Patentansprüche 1 und 8. Außerdem ist ein Herstellungsverfahren nach Anspruch 10 angegeben.

Der Bauelementträger mit einem Mehrschichtträgerkörper weist ein Substrat auf, in dem ein strukturierter Funktionsbereich ist, ausgebildet als integrierte Wärmesenke. Das Substrat erstreckt sich sowohl seitlich als auch zumindest teilweise oberhalb und unterhalb des Funktionsbereichs. Eine Isolationsschicht ist an der Unterseite des Mehrschichtträgerkörpers, auf der ein Wärmesenkenelement angeordnet ist. Flache Strukturen ragen aus einem zylindrischen Grundkörper des Funktionsbereichs parallel zu Längs- und/oder Querachse in das Substrat, sodass sich das Substrat oberhalb und/oder unterhalb der flachen Strukturen erstreckt.

Der Trägerkörper weist neben dem Substrat auch einen strukturierten Funktionsbereich auf, das heißt einen räumlich begrenzten Funktionsbereich innerhalb des Substrats, der eine Funktion übernimmt, beispielsweise Wärme- oder Stromleitung. Somit lässt sich eine integrierte Wärmesenke ausbilden, mittels derer die Wärme vom Bauelement abgeleitet werden kann. Der Funktionsbereich streckt sich üblicherweise vertikal über mehrere Schichten.

Die Wärmeabfuhr von der Wärmequelle, bei der es sich beispielsweise um eine LED handeln kann, zum Gehäuse kann über vertikal und/oder horizontal im Substrat verlaufende thermische Wärmesenken in Form eines thermisch optimierten Blocks, sowie die Verwendung einer Keramik mit hoher thermischer Leitfähigkeit erfolgen.

Dies ermöglicht eine gute Wärmeableitung bei gleichzeitig geringer Dicke des Trägerkörpers. Die Integration von ultradünnen Schutzbauelementen, die beispielsweise nur 0,1 mm dick oder dünner sind, ist möglich. Solche Schutzbauelemente können vor elektrostatischen Entladungen (beispielsweise durch MLV-Elemente/Multilayervaristoren, das heißt Vielschichtvaristoren oder durch TVS-Elemente) und Überströmen (beispielsweise durch PTC-Elemente, Kaltleiter) schützen oder als Temperatursensoren (NTC-Elemente, Heißleiter) eingesetzt werden.

Der Vielschicht- oder Mehrschichtträgerkörper hat einen geschichteten Aufbau, da er aus einer Vielzahl Folien aufgebaut ist, die zu einem Stapel geschichtet wurden, die anschließend beispielsweise durch Sintern zum Trägerkörper verfestigt wurden. Diese Folien weisen Substrat- und Strukturbereiche auf. Der dreidimensionale strukturierte Funktionsbereich entsteht durch die aufeinanderliegenden Strukturbereiche der Folien. Senkrechte Mantelflächen des Funktionsbereichs entstehen durch aufeinandergeschichtete Folien, bei denen die Konturen, das heißt die Ränder, der Strukturbereiche übereinstimmen. Kurvige Mantelflächen des Funktionsbereichs entstehen durch Folien, bei denen die Konturen von Schicht zu Schicht derart geringfügig einander abweichen, sodass sie aufeinandergeschichtet den kurvigen Mantelverlauf ergeben. Kanten im Mantel lassen sich dadurch erzielen, indem die Kontur eines Strukturbereichs signifikant von der darunterliegenden Kontur abweicht, sodass der über die darunterliegende Kontur hinausreichende Strukturbereich die Unterseite eines herausragenden Strukturbereichs bildet, die eine Kante an der Schichtgrenze aufweist. Diese Kante verläuft folglich parallel zu Längs- oder Querrichtung oder der davon aufgespannten Ebene.

Solch ein geschichtet aufgebauter Trägerkörper, wie zuvor und im Folgenden beschrieben, lässt sich durch Drucken von Folien durch Auftragen einer ersten Paste in einem ersten Areal und Auftragen einer zweiten Paste in einem zweiten Areal, Stapeln und Laminieren der Folien herstellen, um eine innige Verbindung der Areale und der Folien zu erreichen. Laminieren geht mit einer Wärmeeinwirkung und optionaler Druckeinwirkung einher.

Durch das Drucken des ersten und zweiten Areals innerhalb einer Folienkontur wird eine Folie für einen Folienstapel hergestellt. Eine Folie ist ein dünnes Blatt geformt aus den gedruckten Arealen der getrockneten ersten und zweiten Paste. Sie umfasst das gedruckte erste und zweite Areal, deren Dicke der Foliendicke entspricht. Ein drittes Areal kann mit einer dritten Paste gedruckt werden. Der Mehrschichtträgerkörper wird aus innig verbundenen, gestapelten und gedruckten Folien, die mit verschiedenen Pasten gedruckte Areale aufweisen, gefertigt. Nach der Stapelung ergeben die aufgeschichteten ersten Areale das Substrat, die zweiten Areale formen den strukturierten Funktionsbereich. Die Pasten umfassen das Material des Substrats beziehungsweise des Funktionsbereichs.

Dadurch lassen sich beliebig strukturierte Funktionsbereiche herstellen. Der Funktionsbereich kann beispielsweise ein durch das Substrat durchgehender Bereich sein, der als Durchkontaktierung oder Wärmesenke dienen kann.

An der Unterseite des Mehrschichtträgerkörpers ist ein Wärmesenkenelement montiert, mittels dessen die durch das Substrat geleitete Wärme abgeleitet wird. Eine Isolationsschicht ist zwischen dem Funktionsbereich und dem Wärmesenkenelement vorgesehen, um mögliche elektrische Beeinflussungen durch die integrierte Wärmesenke zu verhindern. 1

Der Funktionsbereich ist derart geformt, dass flache Strukturen, insbesondere strukturierte Schichten, aus einem Grundkörper des Funktionsbereichs parallel zu Längs- und/oder Querachse in das Substrat ragen. Der Grundkörper hat zylindrische Gestallt, das heißt mit paralleler Grund- und Deckfläche und einer Mantelfläche, die von parallelen Geraden gebildet wird. Die herausragenden strukturierten Schichten können in verschiedenen Ebenen übereinander oder zueinander versetzt angeordnet sein. Sie dienen zur verbesserten mechanischen Anpassung und vermindern Materialspannungen.

Der Funktionsbereich oder der weitere Bereich kann eine Kavität oder ein Hohlraum sein. In diesem Fall weisen die Folien, aus denen der Trägerkörperstapel geformt wird, eine Aussparung auf. Ein derartiger Hohlraum oder eine derartige Kavität kann eine beliebige Struktur haben.

Der Funktionsbereich weist Material auf, das sich von dem des Substrats unterscheidet. Der Funktionsbereich kann metallen sein oder metallene Schichten aufweisen, beispielsweise Kupfer, das eine gute Wärme- und Stromleitfähigkeit hat. Zur Ausbildung einer integrierten Wärmesenke im Substrat durch den Funktionsbereich wird Material verwendet, das eine erhöhte thermische Leitfähigkeit im Vergleich zum Substrat aufweist. Die thermische Leitfähigkeit des Materials für den Funktionsbereich ist vorteilhafterweise größer als 100 W/mK. Das Substrat ist eine Keramik, die beispielsweise Al₂O₃ umfasst. Das Substrat kann Al₂O₃ und Gläser oder LTCC-Keramiken umfassen.

Eine Isolationsschicht kann auf Ober- und Unterseite des Mehrschichtträgerkörpers vorgesehen sein. Solche oben beschriebenen Mehrschichtträgerkörper können in einer Bauelementanordnung mit einem Bauelementträger mit einem Mehrschichtträgerkörper aufweisend ein Substrat, in dem ein strukturierter Funktionsbereich angeordnet ist, welcher als integrierte Wärmesenke dient, und ein Bauelement, das auf dem Funktionsbereich angeordnet ist, vorgesehen sein. Eine solche Bauelementanordnung weist eine Isolationsschicht an der Unterseite des Mehrschichtträgerkörpers auf, auf der eine Wärmesenke angeordnet ist. Der Funktionsbereich kann eine kubische Grundform aufweisen und seine Querschnittsfläche an der Oberseite des Trägerkörpers kann der des Bauelements entsprechen oder darüber hinausgehen. Diese ermöglicht eine gute Wärmeableitung. Ferner kann der Funktionsbereich strukturierte Schichten aufweist, die parallel zu Längs- und/oder Querachse in das Substrat ragen und sich das Substrat oberhalb und/oder unterhalb dieser strukturierten Schichten erstreckt.

Nachfolgend wird die Erfindung unter Bezugnahme auf die Zeichnung anhand von Ausführungsbeispielen erklärt.

Es zeigen:
- Figuren 1 und 2: Schnittdarstellungen eines Ausführungsbeispiels, das nicht unter die Ansprüche fällt,
- Figuren 3 und 4: Schnittdarstellungen eines weiteren Ausführungsbeispiels, das nicht unter die Ansprüche fällt,

- Figuren 5 und 6: Schnittdarstellungen eines erfindungsgemäßen Ausführungsbeispiels,
- Figur 7: eine Schnittdarstellung eines weiteren erfindungsgemäßen Ausführungsbeispiels,
- Figuren 8 und 9: Schnittdarstellungen eines weiteren erfindungsgemäßen Ausführungsbeispiels und
- Figuren 10, 11 und 12: Schnittdarstellungen noch eines weiteren erfindungsgemäßen Ausführungsbeispiels.

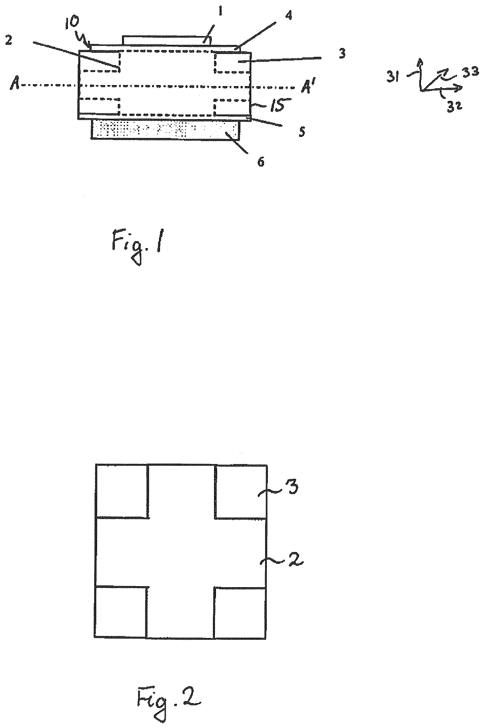

Figur 1 zeigt ein Ausführungsbeispiel einer Bauelementträgeranordnung mit einem Bauelementträger 10 mit einem darauf angeordneten Bauelement 1, welches als Wärmequelle wirkt. Die Darstellung ist ein Schnitt entlang der Hochachse 31 der Bauelementträgeranordnung. Figur 2 zeigt einen Schnitt entlang der Linie A-A' durch diese Bauelementträgeranordnung. Der Schnitt verläuft in einer Ebene parallel zu der von Längs- und Querachse 32, 33 aufgespannten Ebene. Die Achsen sind im Achsenkreuz 31, 32, 33 dargestellt.

Der Bauelementträger 10 umfasst einen Mehrschichtträgerkörper 15, der als Träger sowohl für separate Komponenten oder Bauelemente 1 als auch Leiterstrukturen dienen kann. Der Mehrschichtträgerkörper 15 ist aus gestapelten Folien gefertigt und umfasst ein Substrat 3, das ein Trägermaterial aufweist, beispielsweise eine Al₂O₃-Keramik. Im Substrat 3 ist ein strukturierter Funktionsbereich 2 vorgesehen. Dieser Funktionsbereich 2 ist ein Bereich mit lokal erhöhter thermischer Leitfähigkeit, der als integrierte Wärmesenke zur Wärmeableitung dient.

Auf der Oberseite des Mehrschichtträgerkörpers 15 ist eine Leiterstruktur 4 vorgesehen, mittels der die Kontaktierung des Bauelements 1 und/oder eine Umverdrahtung erfolgen kann. Eine solche Leiterstruktur 4 kann Lötpads zur Kontaktierung des Bauelements 1 umfassen, Leiterbahnen zur Spannungs- und Stromversorgung sowie zur Signalübertragung. Die Leiterbahnen können zu Anschlüssen auf der Oberseite verlaufen oder zu Durchkontaktierungen im Substrat 4. Eine solche Leiterstruktur 4 kann metallen sein, beispielsweise aus Kupfer.

Auf dem Mehrschichtträgerkörper 15 ist ein Bauelement 1 fixiert, das im Betrieb Wärme abstrahlt. Ein solches Bauelement 1 kann eine LED sein.

An der Unterseite des Mehrschichtträgerkörpers 15 ist eine elektrische Isolationsschicht 5 aufgebracht, die aus demselben Material wie das Substrat 3 ausgebildet sein kann oder aus einem anderen Material. Das Material und die Schichtdicke der Isolationsschicht 5 können so gewählt werden, dass eine Spannungsfestigkeit von 3000 V erreicht wird. Die Isolationsschicht 5 erstreckt sich in diesem Ausführungsbeispiel über die gesamte Unterseite der Trägerkörpers 15. Auf der Isolationsschicht 5 ist ein Wärmesenkenelement 6 aufgebracht. Hierbei handelt es sich um ein Element, mittels dessen die durch das Substrat 3 geleitete Wärme des Bauelements 1 abgeleitet oder abgestrahlt wird, beispielsweise um einen Kühlkörper oder ein Gehäuseteil. Aber auch eine Kontaktierung ist denkbar.

Diesem Ausführungsbeispiel verläuft der Funktionsbereich 2 von der Oberseite des Mehrschichtträgerkörpers 15 bis zur Isolationsschicht 5. Die Struktur 2 hat im Bereich benachbart zum Bauelement 1 und zur Isolationsschicht 5 einen quadratischen Querschnitt, der geringfügig über die Grundfläche des Bauelements 1 hinausragt. Im Bereich der Schnittebene A-A' ragen die Seitenbereiche der Struktur 2 bis zum Rand des Mehrschichtträgerkörpers 15, sodass sich ein kreuzförmiger Querschnitt ergibt, wie in Figur 2 erkennbar. Ober- und unterhalb der herausragenden Strukturbereiche erstreckt sich das Substrat 3.

Die achsenkreuzförmige Struktur des Funktionsbereichs 2 erlaubt nicht nur die Ableitung der Wärme senkrecht zum Bauelement 1, sondern auch eine Ableitung der Wärme in horizontaler Richtung, welche durch die kreuzförmige Querschnittsverbreiterung erfolgt.

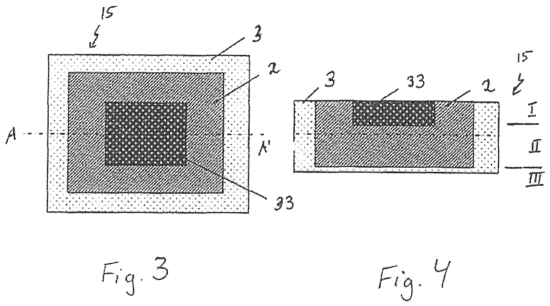

Figur 3 zeigt eine Aufsicht auf ein Ausführungsbeispiel eines Mehrschichtträgerkörpers und einen Schnitt (rechts) durch diesen entlang der Linie A-A'.

In diesem Ausführungsbeispiel ist eine wannenförmige metallene Struktur oder Funktionsbereich 2 an den Seitenflächen und am Boden von einem Keramiksubstrat 3 umgeben. In der Struktur 2 ist eine weitere, quaderförmige Struktur 33, das heißt ein weiterer Bereich, aus einem weiteren Material, beispielsweise einem anderen Keramikmaterial, vorgesehen.

Dieser Mehrschichtträgerkörper 15 ist aus drei verschiedenen Folientypen aufgebaut. Im oberen Bereich I entspricht deren Arealsanordnung der Aufsicht. Das rechteckförmige dritte Areal 33 ist von den rahmenförmigen zweiten und ersten Arealen 2, 3 umgeben. Im darunterliegenden Bereicht II weisen die Folien ein zweites Areal 1 ohne Innenkontur auf. Das zweite Areal 2 ist rechteckförmig. Im unteren Bereich III sind die Folien ganzflächig mit der Paste für das erste Areal 3 bedruckt.

Die Stapelung solch identischer Folien in jedem der Bereiche I, II, III mit identischen Konturen ergibt einen Mehrschichtträgerkörper 15, bei dem die Mantelflächen der Strukturen in diesen Bereichen die sich aus den übereinanderliegenden Konturen ergeben, parallel zur Hochachse des Trägerköpers, das heißt senkrecht zu den Folienschichten, verlaufen. Benachbarte Folien, bei denen verschiedene Areale aufeinander liegen, formen die waagerechten Grenzflächen zwischen den wannenförmigen Strukturen.

In einem alternativen Ausführungsbeispiel kann statt der weiteren Struktur 33 eine Kavität vorgesehen sein. Diese wird aus Folien aufgebaut, die an entsprechender Stelle eine Aussparung, das heißt einen unbedruckten Bereich aufweisen.

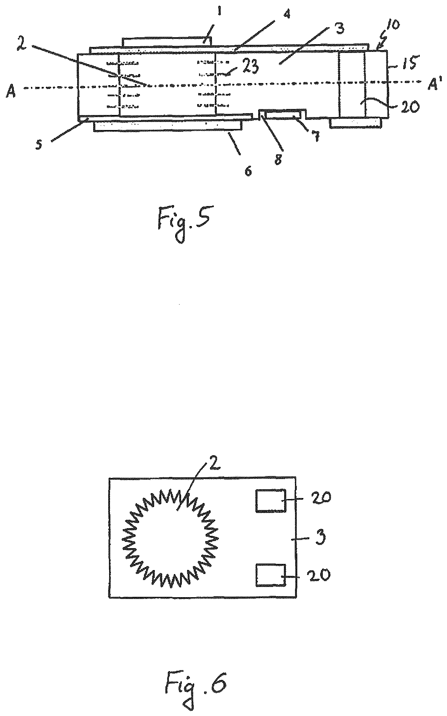

Die Figur 5 zeigt ein weiteres Ausführungsbeispiel einer Bauelementträgeranordnung mit einem Bauelementträger 10 mit einem darauf angeordneten Bauelement 1, welches als Wärmequelle wirkt. Die Darstellung ist ein Schnitt entlang der Hochachse der Bauelementträgeranordnung. Figur 6 zeigt einen Schnitt entlang der Linie A-A' durch diese Bauelementträgeranordnung. Der Schnitt verläuft in einer Ebene parallel zu der von Längs- und Querachse aufgespannten Ebene.

Im Folgenden werden im Wesentlichen die Unterschiede zu den vorangegangenen Ausführungsbeispielen beschrieben.

Das in den Figuren 5 und 6 gezeigte Ausführungsbeispiel einer Bauelementträgeranordnung weist neben dem auf der Oberseite angeordneten Bauelement 1, beispielsweise eine LED, noch ein weiteres diskretes Bauelement 7 auf, das in einer Kavität 8 in der Unterseite des Trägerkörper 15 angeordnet ist.

Dieses Ausführungsbeispiel umfasst drei strukturierte Funktionsbereiche 2. Ein erster Funktionsbereich 2 erstreckt sich unterhalb des auf der Oberseite angeordneten Bauelements 1 und verläuft von der Oberseite des Trägerkörpers 15 bis zur Isolationsschicht 5. Dieser als Wärmesenke dienende Funktionsbereich 2 hat eine zylinderförmige Grundform mit einem Querschnitt, dessen runde Grundform einen gezackten Rand aufweist, wie in Figur 6 ersichtlich ist. Aus der senkrechten Mantelfläche ragen waagerecht verlaufende Bereiche 23 ins Substrat 3, die als strukturierte Schichten ausgebildet sind. Diese ins Substrat laufenden Bereiche 23 können eine Querschnittsvergrößerung des Grundkörpers sein, deren Kontur einen gleichen Abstand von der Kontur des Mantels des Grundkörpers hat. Sie können alternativ streifen- oder stegförmig ausgebildet sein. Wegen ihrer Form können sie auch als Elektrodenstruktur bezeichnet werden. Sie verbessern die mechanische Anpassung zwischen Metall und Keramik im Übergang vom Substrat zum Funktionsbereich, indem beispielsweise Materialspannungen vermieden werden.

Unterhalb des ersten Funktionsbereichs 2 ist zwischen diesem und der Wärmesenke eine Isolationsschicht 5 vorgesehen. Diese verläuft unterhalb des Bauelements 1, aber über dessen Grundfläche hinausragend, aber nicht großflächig über die gesamte Unterseite des Mehrschichtträgerkörpers 15.

Die Bauelementträgeranordnung weist außerdem einen zweiten und dritten Funktionsbereich 20 auf, die zwischen der Leiterstruktur 4 auf der Oberseite des Mehrschichtträgerkörpers 15 und einem Wärmesenkenelement 6 auf der Unterseite verlaufen. Diese Funktionsbereiche sind zylinderförmig mit rechteckigem Querschnitt. Sie können als Durchkontaktierung oder Wärmesenke für ein weiteres, nicht dargestelltes, Bauelement dienen.

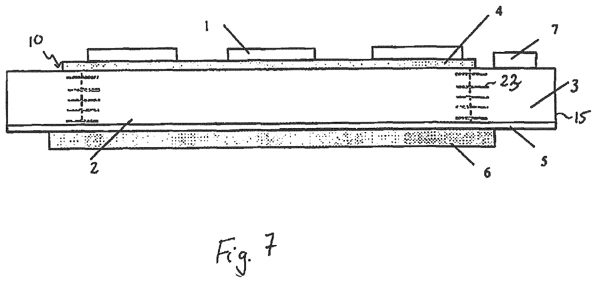

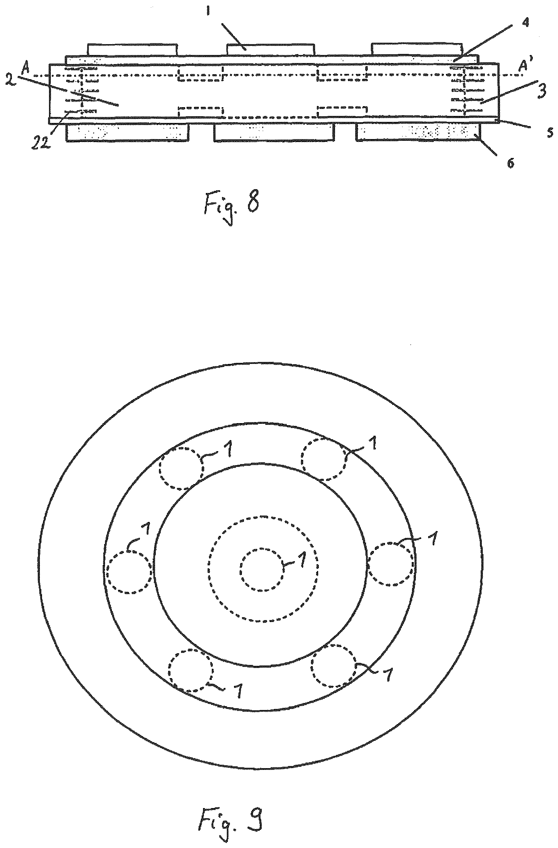

Die Figur 7 zeigt ein weiteres Ausführungsbeispiel einer Bauelementträgeranordnung mit einem Bauelementträger 10 mit mehreren darauf angeordneten Bauelementen 1, welche als Wärmequelle fungieren. Die Darstellung ist ein Schnitt entlang der Hochachse der Bauelementträgeranordnung. Die räumliche Anordnung der LEDs kann wie in Figur 9 dargestellt sein.

Im Folgenden werden im Wesentlichen die Unterschiede zu den vorangegangenen Ausführungsbeispielen beschrieben.

Die Bauelementträgeranordnung weist mehrere auf der Oberseite angeordnete Bauelemente 1 auf. Hierbei kann es sich um LEDs handeln, die im Betrieb Wärme entwickeln. Unterhalb des Bereichs, in dem die Bauelemente 1 angeordnet sind, erstreckt sich der strukturierte Funktionsbereich 2, der als gemeinsame Wärmesenke für die Bauelemente 1 dient. Der Funktionsbereich 2 hat einen zylinderförmigen Grundkörper, der sich von der Oberseite des Mehrschichtträgerkörpers 15 bis zur Isolationsschicht 5 erstreckt. Auf der Isolationsschicht 5 ist ein gemeinsames Wärmesenkenelement 6 vorgesehen. Ferner sind strukturierte Schichten 23 vorgesehen, die sich waagerecht ins Substrat 3 erstrecken. Diese sind in verschiedenen Ebenen übereinander angeordnet. Ober- und unterhalb dieser Bereiche erstreckt sich das Substrat 3.

Ferner ist jenseits des Funktionsbereichs 2 ein weiteres, diskretes Bauelement 7 auf der Oberseite des Trägerkörpers 15 angeordnet, bei dem es sich beispielsweise um einen integrierten NTC-Temperatursensor oder um ein MLV-Element als ESD-Schutz (ESD ist kurz für englisch "electrostatic discharge", das heißt elektrostatische Entladung,) handeln kann.

Die Figur 8 zeigt ein weiteres Ausführungsbeispiel einer Bauelementträgeranordnung umfassend einen Bauelementträger 10 mit einem darauf angeordneten Bauelementen 1, welche als Wärmequelle fungieren. Die Darstellung ist ein Schnitt entlang der Hochachse der Bauelementträgeranordnung. Figur 9 zeigt einen Schnitt entlang der Linie A-A' durch diese Bauelementträgeranordnung. Der Schnitt verläuft in einer Ebene parallel zu der von Längs- und Querachse aufgespannten Ebene.

Im Folgenden werden im Wesentlichen die Unterschiede zum vorangegangenen Ausführungsbeispiel beschrieben. Bei diesem Ausführungsbeispiel handelt es sich um eine Bauelementträgeranordnung mit sieben Bauelementen 1, beispielsweise LEDs. Figur 9 zeigt die räumliche Anordnung der Bauelemente 1. Eines ist zentral angeordnet, weitere sind ringförmig um dieses Bauelement 1 angeordnet.

Figur 8 unterscheidet sich vom vorhergehenden Ausführungsbeispiel im Wesentlichen durch die Struktur des Funktionsbereichs 2. Auch in diesem Ausführungsbeispiel ist ein ausgedehnter Funktionsbereich 2 als Wärmesenke für die Bauelemente 1 vorgesehen. Im mittleren Bereich des Trägerkörpers 15 erstreckt sich der strukturierte Funktionsbereich 2 weiträumig, wird aber nur unterhalb der Bauelemente und Wärmesenken an die Ober- beziehungsweise Unterseite geführt. Somit sind nicht nur am Rand des Mehrschichtträgerkörpers 15 Substratbereiche 3, sondern auch an der Trägerkörperoberseite zwischen den Bauelementen 1. Ferner sind auch separate Wärmesenkenselemente 6 unter den Bauelementen 1 vorgesehen. Der Funktionsbereich weist auch im unteren Bereich Substratbereiche zwischen zu den Wärmesenkenelementen 6 verlaufenden Bereichen des Funktionsbereichs auf. Die im oberen und unteren Bereiche des Mehrschichtträgerkörpers verlaufenden Bereiche des Funktionsbereichs können inselförmig sein, sodass ihr Querschnitt im Wesentlichen der Grundfläche der Bauelemente 1 entspricht oder kreis- beziehungsweise ringförmig, sodass die Bauelemente 1 auf dem Kreis beziehungsweise Ring angeordnet sind, wie in Figur 9 skizziert.

Auch in diesem Ausführungsbeispiel ragen strukturierte Schichten 23 aus dem Grundkörper des Funktionsbereichs in das Substrat 3 hinein.

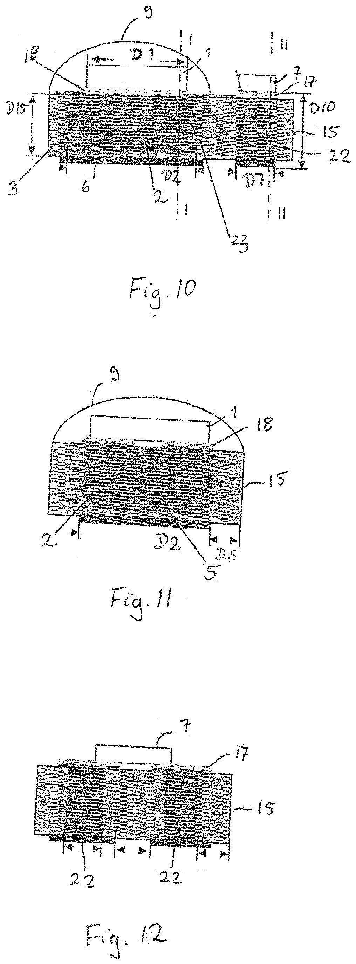

Figur 10 zeigt einen Schnitt durch ein weiteres Ausführungsbeispiel, ähnlich dem in den Figuren 5 und 6 gezeigten.

In diesem Ausführungsbeispiel sind eine LED als Bauelement 1 mit starker Wärmeentwicklung sowie ein MLV-Element als exemplarisches weiteres Bauelement 7 auf einem Mehrschichtträgerkörper 15 angeordnet. Das Bauelement 1 ist unter einer Linse 9 positioniert.

Die Breite D1 einer solchen LED kann beispielsweise 1000 µm betragen. Sie ist durch Lot, beispielsweise SnAgCu aufweisend, auf Lotpads 18 auf dem Trägerkörper 15 fixiert. Die Breite D7 des weiteren Bauelements 7 kann 300 µm betragen. Es ist auf Lotpads 17, beispielsweise Ag/Ni/Sn umfassend, fixiert.

Auf der Unterseite des Mehrschichtträgerkörpers 15 sind Wärmesenkenelemente 6 angeordnet. Ein solcher Mehrschichtträgerkörper 15 kann eine Dicke D10 von 500 µm haben, wobei das Substrat 3 eine Dicke D15 von 400 µm hat.

Im Substrat 3 sind ein erster Funktionsbereich 2, der als thermischer Block oder Wärmesenke für das Bauelement 1 dient, sowie zwei weitere Funktionsbereiche 22 als Durchkontaktierungen unterhalb des weiteren Bauelements 7 angeordnet. Die Breite D2 der integrierten Wärmesenke beträgt sowohl in Längs- als auch Querrichtung 1500 µm. Der Abstand zum Rand des Trägerkörpers beträgt 700 µm (siehe Figur 11). Die Breite der weiteren Funktionsbereiche entspricht der des weiteren Bauelements 7. Die Breite D2 des Grundkörpers der integrierten Wärmesenke beträgt sowohl in Längs- als auch Querrichtung 1500 µm. Der Abstand D3 zum Rand des Trägerkörpers beträgt 700 µm (siehe Figur 9). Die Breite der weiteren Funktionsbereiche entspricht der des weiteren Bauelements 7 und beträgt 300 µm.

Der Mehrschichtträgerkörper 15 hat einen geschichteten Aufbau und umfasst eine Vielzahl von Folien, die gestapelt und laminiert wurden, um den Trägerkörper 15 zu formen. Die einzelnen Folien umfassen Substratareale, deren Gestaltung dem Schnitt durch den Trägerkörper in der entsprechenden Ebene entspricht. Derartige Folien können durch Drucken mit verschiedenen Pasten für die verschiedenen Areale gefertigt werden, welche anschließend gestapelt und laminiert werden. Auf diese Weise ist es möglich, beliebige Strukturen innerhalb des Substrats 3 herzustellen. So lassen sich beispielsweise die aus dem Grundkörper des Funktionsbereichs herausragenden Bereiche 23 in einfacher Weise fertigen, indem der gedruckte Funktionsbereich einer solchen Schicht über den der darunterliegenden und der darüberliegenden Schicht hinausragt. Mit anderen Worten: Über die Konturen des Grundkörpers hinausgehende Strukturbereiche einer Folienschicht, oder mehrerer Folienschichten, bilden die ins Substrat 3 ragenden Bereiche 23.

Figur 11 und Figur 12 zeigen zwei weitere Schnitte durch das Bauelement entlang der Linien I-I und II-II in Figur 10. Figur 11 zeigt den Schnitt I-I, in dem deutlich erkennbar ist, dass die LED mittels zweier Kontakte kontaktiert wird. Im Schnitt 2-2 ist erkennbar, dass Gleiches auch für das weitere Bauelement 7 gilt.

Die Merkmale der Ausführungsbeispiele können kombiniert werden.

## Patentansprüche

1. Bauelementträger (10) mit einem Mehrschichtträgerkörper (15) aufweisend ein Substrat (3), in dem ein strukturierter Funktionsbereich (2) ist, ausgebildet als integrierte Wärmesenke,
- wobei das Substrat (3) sich sowohl seitlich als auch zumindest teilweise oberhalb und unterhalb des Funktionsbereichs (2) erstreckt,,
- wobei an einer Unterseite des Mehrschichtträgerkörpers (15) eine elektrische Isolationsschicht (5) ist, auf der ein Wärmesenkenelement (6) aufgebracht ist,
**dadurch gekennzeichnet, dass**
flache Strukturen (22) .aus einem zylindrischen Grundkörper des Funktionsbereichs (2) parallel zu einer Längs- und/oder Querachse in das Substrat (3) ragen, sodass sich das Substrat (3) oberhalb und/oder unterhalb der flachen Strukturen (22) erstreckt.

2. Bauelementträger (10) nach Anspruch 1,
wobei der Funktionsbereich (2) zumindest eine parallel zu Längs- oder Querrichtung oder der davon aufgespannten Ebene verlaufende Kante aufweist.

3. Bauelementträger (10) nach Anspruch 1 oder 2,
wobei der Funktionsbereich (2) ein durch das Substrat (3) durchgehender Bereich ist.

4. Bauelementträger (10) nach einem der vorhergehenden Ansprüche,
wobei der Funktionsbereich (2) oder der weitere Bereich eine Kavität (8) oder ein Hohlraum ist.

5. Bauelementträger (10) nach einem der vorhergehenden Ansprüche,
wobei der Funktionsbereich (2) ein Material aufweist, das sich von dem des Substrats (3) unterscheidet und wobei der Funktionsbereich (2) metallen ist oder metallene Schichten aufweist.

6. Bauelementträger (10) nach einem der vorhergehenden Ansprüche,
wobei das Material des Funktionsbereichs (2) eine erhöhte thermische Leitfähigkeit im Vergleich zum Substrat (3) aufweist.

7. Bauelementträger (10) nach einem der vorhergehenden Ansprüche,
wobei das Substrat (3) Al₂O₃ oder Al₂O₃ und Gläser umfasst.

8. Bauelementträgeranordnung umfassend einen Bauelementträger (10) gemäß Anspruch 1 und ein Bauelement (1), das auf dem Funktionsbereich (2) angeordnet ist.

9. Bauelementträgeranordnung nach Anspruch 8,
wobei der Funktionsbereich (2) eine kubische Grundform aufweist und seine Querschnittsfläche an der Oberseite des Mehrschichtträgerkörpers (15) der des Bauelements (1) entspricht oder darüber hinausgeht.

10. Verfahren zur Herstellung eines Bauelementträgers (10) mit einem Mehrschichtträgerkörper (15) gemäß der Ansprüche 1 bis 7 durch
- Drucken von Folien durch Auftragen einer ersten Paste in einem ersten Areal und Auftragen einer zweiten Paste in einem zweiten Areal,
- Stapeln und Laminieren der Folien.

## Claims

1. Component carrier (10) comprising a multilayer carrier body (15) having a substrate (3) containing a structured functional region (2) designed as an integrated heat sink,
- wherein the substrate (3) extends both laterally and also at least partly above and below the functional region (2),
- wherein there is an electrical insulation layer (5) at an underside of the multilayer carrier body, on which electrical insulation layer a heat sink element (6) is applied, **characterized in that** flat structures (22) project from a cylindrical main body of the functional region (2) parallel to a longitudinal and/or transverse axis into the substrate (3) such that the substrate (3) extends above and/or below the flat structures (22).

2. Component carrier (10) according to Claim 1,
wherein the functional region (2) has at least one edge running parallel to a longitudinal or transverse direction or the plane spanned thereby.

3. Component carrier (10) according to Claim 1 or 2,
wherein the functional region (2) is a region extending continuously through the substrate (3).

4. Component carrier (10) according to any of the preceding claims,
wherein the functional region (2) or the further region is a cavity (8) or a hollow space.

5. Component carrier (10) according to any of the preceding claims,
wherein the functional region (2) comprises a material which differs from that of the substrate (3) and wherein the functional region (2) is metallic or comprises metallic layers.

6. Component carrier (10) according to any of the preceding claims,
wherein the material of the functional region (2) has an increased thermal conductivity in comparison with the substrate (3).

7. Component carrier (10) according to any of the preceding claims,
wherein the substrate (3) comprises Al₂O₃ or Al₂O₃ and glasses.

8. Component carrier arrangement comprising a component carrier (10) according to Claim 1 and a component (1) arranged on the functional region (2) .

9. Component carrier arrangement according to Claim 8,
wherein the functional region (2) has a cubic basic shape and its cross-sectional area at the top side of the multilayer carrier body (15) corresponds to or projects beyond that of the component (1).

10. Method for producing a component carrier (10) comprising a multilayer carrier body (15) according to Claims 1 to 7 by
- printing films by applying a first paste in a first area and applying a second paste in a second area,
- stacking and laminating the films.

## Revendications

1. Support de composant (10) comportant un corps de support multicouche (15) présentant un substrat (3) dans lequel se trouve une zone fonctionnelle structurée (2), qui est réalisée sous la forme d'un puits thermique intégré,
- dans lequel le substrat (3) s'étend à la fois latéralement et au moins partiellement au-dessus et en-dessous de la zone fonctionnelle (2),
- dans lequel une couche d'isolation électrique (5) sur laquelle est monté un élément de puits thermique (6) est prévue sur une face inférieure du corps de support multicouche (15),
**caractérisé en ce que**
des structures planes (22) font saillie dans le substrat (3) par rapport à un corps de base cylindrique de la zone fonctionnelle (2) parallèlement à un axe longitudinal et/ou transversal, de sorte que le substrat (3) s'étend au-dessus et/ou en-dessous des structures planes (22).

2. Support de composant (10) selon la revendication 1, dans lequel la zone fonctionnelle (2) présente au moins un bord s'étendant parallèlement à la direction longitudinale ou transversale ou au plan sous-tendu par celle-ci.

3. Support de composant (10) selon la revendication 1 ou 2, dans lequel la zone fonctionnelle (2) est une zone passant à travers le substrat (3).

4. Support de composant (10) selon l'une des revendications précédentes,
dans lequel la zone fonctionnelle (2) ou l'autre zone est une cavité (8) ou un espace creux.

5. Support de composant (10) selon l'une des revendications précédentes,
dans lequel la zone fonctionnelle (2) comporte un matériau différent de celui du substrat (3) et dans lequel la zone fonctionnelle (2) est métallique ou comporte des couches métalliques.

6. Support de composant (10) selon l'une des revendications précédentes,
dans lequel le matériau de la zone fonctionnelle (2) présente une conductivité thermique supérieure à celle du substrat (3).

7. Support de composant (10) selon l'une des revendications précédentes,
dans lequel le substrat (3) comprend de l'Al₂O₃ ou de l'Al₂O₃ et des verres.

8. Dispositif de support de composant comprenant un support de composant (10) selon la revendication 1 et un composant (1) disposé sur la zone fonctionnelle (2).

9. Dispositif de support de composant selon la revendication 8,
dans lequel la zone fonctionnelle (2) présente une forme de base cubique et sa surface de section transversale, sur la face supérieure du corps de support multicouche (15), correspond à celle du composant (1) ou dépasse au-dessus de celle-ci.

10. Procédé de fabrication d'un support de composant (10) comportant un corps de support multicouche (15) selon les revendications 1 à 7, par
- impression de films en appliquant une première pâte dans une première région et en appliquant une deuxième pâte dans une deuxième région,
- empilage et stratification des films.
